(19) **Europäisches Patentamt**
**European Patent Office**
**Office européen des brevets**

(11) **EP 1 685 648 B1**

(12) **EUROPÄISCHE PATENTSCHRIFT**

(45) Veröffentlichungstag und Bekanntmachung des Hinweises auf die Patenterteilung:
**14.01.2009 Patentblatt 2009/03**

(51) Int Cl.:
**H03F 3/217** (2006.01)

(21) Anmeldenummer: **04798189.9**

(22) Anmeldetag: **09.11.2004**

(86) Internationale Anmeldenummer:
**PCT/EP2004/052889**

(87) Internationale Veröffentlichungsnummer:
**WO 2005/050832 (02.06.2005 Gazette 2005/22)**

(54) **VERSTÄRKER MIT ENDSTUFEN-GESTEUERTER REGELUNG**

AMPLIFIER PROVIDED WITH A REGULATION SYSTEM CONTROLLED BY THE OUTPUT STAGE

AMPLIFICATEUR REGULE PAR COMMANDE DE L'ETAGE DE SORTIE

(84) Benannte Vertragsstaaten:
**DE**

(30) Priorität: **19.11.2003 DE 10353965**

(43) Veröffentlichungstag der Anmeldung:
**02.08.2006 Patentblatt 2006/31**

(73) Patentinhaber: **SIEMENS AKTIENGESELLSCHAFT**
**80333 München (DE)**

(72) Erfinder: **LENZ, Helmut**
**90522 Oberasbach (DE)**

(56) Entgegenhaltungen:
WO-A-03/055058          WO-A-03/061117
US-A- 5 262 733          US-A- 5 559 467
US-A- 6 124 757

• **HANCOCK J: "A CLASS D AMPLIFIER USING MOSFETS WITH REDUCED MINORITY CARRIER LIFETIME*" JOURNAL OF THE AUDIO ENGINEERING SOCIETY, AUDIO ENGINEERING SOCIETY. NEW YORK, US, Bd. 39, Nr. 9, 1. September 1991 (1991-09-01), Seiten 650-662, XP000226144 ISSN: 0004-7554**
• **WATANABE S ET AL: "DSP-based high precision current tracking control of gradient coil in two-paralleled PWM amplifiers for MRI systems" POWER ELECTRONICS SPECIALISTS CONFERENCE, 1998. PESC 98 RECORD. 29TH ANNUAL IEEE FUKUOKA, JAPAN 17-22 MAY 1998, NEW YORK, NY, USA,IEEE, US, Bd. 1, 17. Mai 1998 (1998-05-17), Seiten 916-921, XP010294962 ISBN: 0-7803-4489-8**

**Beschreibung**

Die Erfindung betrifft einen Verstärker mit endstufen-gesteuerter Regelung sowie ein Verfahren zum endstufen-gesteuerten Regeln eines Verstärkers. Der Verstärker ist ein Gradientenverstärker für ein Magnetresonanzgerät.

Elektrische Verstärker weisen häufig einen zweistufigen Aufbau auf. In einer ersten Stufe erzeugt ein Zwischenkreisgenerator oder ein Netzteil eine Versorgungsspannung mittelmäßiger Höhe oder Präzision. Sie versorgt eine Endstufe, die die Aufgabe hat, ein Ausgangssignal mit den gewünschten Eigenschaften zu generieren. Das Ausgangssignal kann je nach Anforderungen eine gegenüber der Versorgungsspannung hochtransformierte Spannung aufweisen und je nach Anwendung vorgebbare konstante oder zeitlich veränderliche Signalverläufe aufweisen. Für die Verwendung als Gradientenverstärker für Gradientenspulen in Magnetresonanzgeräten müssen besonders schnelle und präzise einzuhaltende zeitliche Ausgangsignalverläufe gewährleistbar sein. Die Elektronik der Endstufe kann dabei so abgestimmt werden, dass bei Versorgung mit der erforderlichen Versorgungsspannung ein Ausgangssignal mit den gewünschten Eigenschaften bei möglichst effizienter Bauweise erzeugbar ist.

Die Präzision, mit der die gewünschten Parameterwerte des Ausgangssignals, z.B. Strom oder Spannung, eingehalten werden können, hängt u.a. von Schwankungen der Versorgungsspannung ab. Schwankungen der Versorgungsspannung können u.U. durch den schaltungstechnischen Aufbau der Endstufe teilweise kompensiert werden. Eine vollständige Kompensation ist so jedoch nicht immer möglich, so dass nicht sämtliche Anforderungen an das Ausgangssignal ohne weiteres erfüllbar sind.

Im Hinblick auf die Qualität des Ausgangssignals wird daher in der Regel ein stabilisiertes Netzteil verwendet. Zusätzlich kann der gewünschte Parameter des Ausgangssignals geregelt werden, wobei der Regler z.B. Schaltzeiten von Schaltelementen der Endstufe regelt. Eine solche Regelung kann optimal auf die gewünschte Arbeitsweise der Endstufe abgestimmt werden, um die Auswirkungen einer schwankenden Versorgungsspannung zu minimieren. Dennoch ist in kritischen Arbeitspunkten, z.B. bei schnell veränderlichen zeitlichen Verläufen des Ausgangssignals, zu beobachten, dass ein Einfluss des Versorgungssignals bestehen bleibt. Je nach Anforderungen an das Ausgangssignal kann daher eine zusätzliche Kompensierung von Versorgungsschwankungen wünschenswert sein.

Die Aufgabe der Erfindung besteht darin, für einen zweistufigen Verstärker eine zusätzliche Kompensationsmöglichkeit für Schwankungen eines Parameters der Energieversorgung zu schaffen.

Die Erfindung löst diese Aufgabe mit einem Verstärker mit den Merkmalen des unabhängigen Patentanspruchs 1 sowie durch ein Verfahren mit den Merkmalen des unabhängigen Patentanspruchs 10.

Ein Grundgedanke der Erfindung besteht darin, einen Gradientenverstärker mit einer Endstufe, die durch eine elektrische Energiequelle versorgbar ist, anzugeben, wobei die Endstufe eingangsseitig mit einer Steuerungseinrichtung verbunden ist, durch deren Steuersignal ein von einem Parameter der Energiequelle abhängiges Ausgangssignal der Endstufe steuerbar ist. Eine Endstufe kann auch aus mehreren in Reihe geschalteten Einzelendstufen bestehen, die von potentialfreien Energiequellen versorgt werden. Zur zusätzlichen Kompensation von Schwankungen in der Energiequelle ist eine Kompensationseinrichtung vorgesehen, die mit der Energiequelle und der Steuerungseinrichtung verbunden ist, und durch die das Steuersignal in Abhängigkeit von dem Wert des Parameters veränderbar ist.

Der Vorteil dieses Aufbaus liegt darin, dass Schwankungen in der Energiequelle nicht erst im Ausgangssignal der Endstufe detektiert werden, um dann kompensiert werden zu können. Stattdessen werden sie bereits im Entstehen und vor Erzeugen eines Ausgangssignals detektiert. Ihr Einfluss auf die Funktion der Endstufe wird bereits im Steuersignal für die Endstufe berücksichtigt und daher von vorneherein, sozusagen proaktiv, kompensiert. Daher werden insbesondere Schwankungen in kritischen Arbeitspunkten, z.B. bei schnellen Änderungen des Ausgangssignals, die häufig mit einem Überschwingen aufgrund der Arbeitsweise der Steuerung der Endstufe verbunden sind, unterdrückt, ohne dass zusätzliche Fehlerquellen wie das genannte Überschwingen die Kompensation beeinflussen könnten. Die Kompensation erfolgt also in direkter Abhängigkeit von dem zu kompensierenden Signal und unabhängig von weiteren, unerwünschten Einflussgrößen.

In einer vorteilhaften Ausgestaltung der Erfindung ist eine Regelungseinrichtung vorgesehen, die eingangsseitig mit der Endstufe und ausgangsseitig mit der Steuerungseinrichtung verbunden ist, und durch deren Reglersignal das Steuersignal in Abhängigkeit vom Ausgangsignal der Endstufe regelbar ist. Die Regelungseinrichtung ist mit der Kompensationseinrichtung verbunden, und durch die Kompensationseinrichtung ist das Reglersignal in Abhängigkeit von dem Wert des Parameters der Energiequelle veränderbar.

Dadurch ergibt sich der Vorteil, dass das Ausgangssignal der Endstufe zunächst durch die Regeleinrichtung möglichst stabil geregelt werden kann, und dass die Kompensationseinrichtung eine zusätzliche Stabilisierung bewirkt. Die Kombination der zwei Einrichtungen bewirkt eine besonders zuverlässige Stabilisierung des Ausgangssignals. In einer weiteren vorteilhaften Ausgestaltung der Erfindung ist die Kompensationseinrichtung derart ausgebildet, dass sie ein von dem Parameter der Energiequelle und von einem Nominal- oder Maximalwert des Parameters abhängiges Kompensationssignal erzeugen kann. Dadurch wird ein Arbeitsbereich für das Kompensationssignal vorgegeben, der in Bezug zu dem gewünschten Signal der Energiequelle steht und daher einen daran angepassten Arbeitsbereich einhält. Dadurch kann für unterschiedliche Nominal- oder Maximalwerte der Energiequelle ein Überschwingen durch eine übermäßig starke Änderung des Kompensationssignals vermieden werden.

Ein weiterer Grundgedanke der Erfindung besteht in einem Verfahren zum Steuern eines Gradientenverstärkers mit einer Endstufe, die durch eine elektrische Energiequelle versorgt wird, umfassend die Schritte:

- Ermitteln eines Parameterwertes der Energiequelle,
- Erzeugen eines Kompensationssignals in Abhängigkeit von dem Parameterwert,
- Erzeugen eines Steuersignals in Abhängigkeit von dem Kompensationssignal,
- Erzeugen eines Ausgangssignals durch die Endstufe in Abhängigkeit von dem Steuersignal.

Dadurch ergibt sich der Vorteil, dass Schwankungen in der Energiequelle direkt erfasst und zur Kompensation herangezogen werden können. Dadurch werden weitere, indirekte Einflussgrößen, die z.B. von der Steuerung oder Funktionsweise der Endstufe herrühren können, nicht berücksichtigt und können sich nicht als Fehlerquellen auf die Kompensation auswirken. Die unmittelbar von der Energiequelle abhängige Kompensation bewirkt eine Stabilisierung des Ausgangssignals der Endstufe.

In einer vorteilhaften Ausgestaltung des Verfahrens sind die folgenden weiteren Schritte umfasst:

- Ermitteln eines Parameterwertes des Ausgangssignals,
- Erzeugen eines Regelsignals in Abhängigkeit von dem Parameterwert des Ausgangssignals,
- Erzeugen des Steuersignals in zusätzlicher Abhängigkeit von dem Regelsignal.

Die Kombination der Verfahrensschritte zur unmittelbaren Kompensation von Schwankungen der Energiequelle sowie zur Regelung des Ausgangssignals der Endstufe bewirkt eine zusätzliche, sozusagen doppelte, Stabilisierung des Ausgangssignals.

Der Verstärker bzw. das Verfahren können in Abhängigkeit von einer Versorgungsspannung eine Ausgangsspannung erzeugen, die durch die Kompensationseinrichtung stabilisiert ist. Weiter kann die Regelung die Ausgangsspannung aufgrund des durch die Endstufe in einer Spule induzierten Stroms regeln.

Die vorgeschlagene spannungs-abhängige, stromgeregelte Verstärkung kann besonders vorteilhaft als Gradientenverstärker für eine Gradientenspule in einem Magnetresonanzgerät eingesetzt werden, wo in schneller zeitlicher Abfolge präzise einzuhaltende Spulenstromänderungen, also Gradienten, erzeugt werden müssen, um schnell wechselnde magnetische Gradientenfelder zu erzeugen.

Aus US 5559467 und US 5262733 sind Klasse-D Verstärker für Lautsprecher bekannt, die Schwankungen der Versorgungsspannung durch Feed-forward reduzieren.

Weitere vorteilhafte Ausgestaltungen der Erfindung sind Gegenstand der abhängigen Patentansprüche und ergeben sich aus der Beschreibung.

Nachfolgend werden Ausführungsbeispiele der Erfindung anhand von Figuren näher beschrieben. Es zeigen:

Figur 1    geregelter zweistufiger Verstärker mit Kompensati- onseinrichtung,

Figur 2    geregelter zweistufiger Verstärker mit Kompensati- onseinrichtung und Reglersignal- Verstärkungseinrichtung,

Figur 3    Verlauf des Steuersignals der Endstufe in Abhängig- keit vom Reglersignal,

Figur 4    Verlauf des Ausgangssignals der Endstufe in Abhän- gigkeit vom Steuersignal,

Figur 5    schematischer Aufbau eines PI-Reglers mit D- Steuerung und steuerbaren Regelparametern,

Figur 6    digitaler Aufbau eines D- Regelgliedes und

Figur 7    digitaler Aufbau eines I- Regelgliedes.

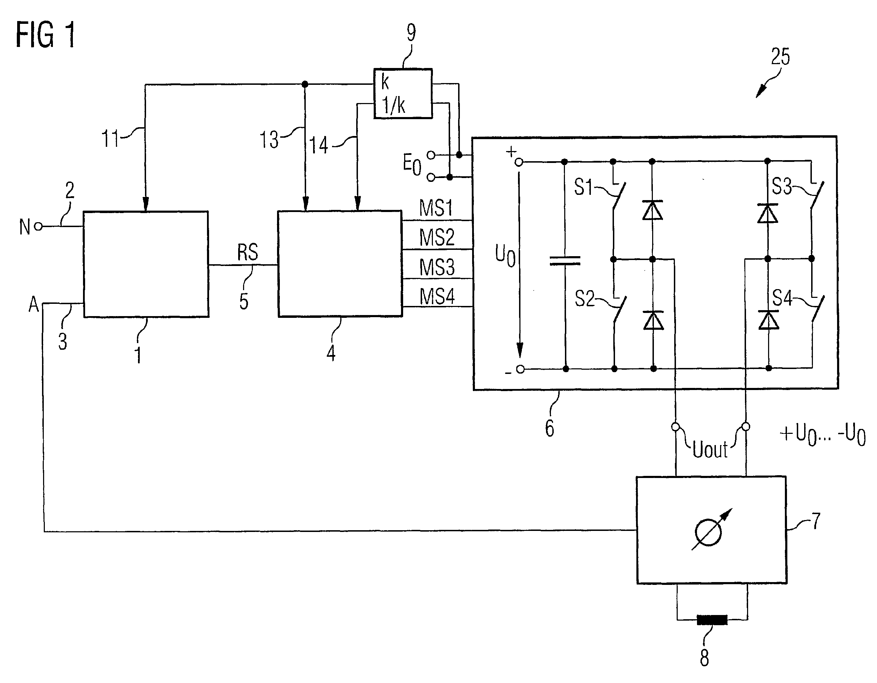

**Figur 1** ist ein geregelter zweistufiger Verstärker 25 mit Kompensationseinrichtung 9 schematisch dargestellt. Der Verstärker 25 weist eine elektrische Energieversorgung $E_0$ auf, die eine Endstufe 6 versorgt. Die Endstufe 6 erzeugt ein Ausgangssignal $U_{out}$, das zum Betreiben eines Verbrauchers 8, hier dargestellt als Spule, genutzt wird.

Ein Parameterwert des Ausgangssignals $U_{out}$ wird durch eine Messeinrichtung 7 ermittelt und über eine Istwertleitung 3, in der Darstellung zusätzlich mit A für "actual" bezeichnet, einer Regelungseinrichtung 1 zugeführt. Als weiterer Signaleingang weist die Regelungseinrichtung 1 eine Sollwertleitung 2 auf, in der Darstellung zusätzlich mit N für "nominal" bezeichnet. Das Reglersignal RS wird über eine Reglerausgangsleitung 5 der Steuerungseinrichtung 4 zugeführt, die über vier (bei einer Reihenschaltung von mehreren Endstufen entsprechend mehr) Signalleitungen für die Steuersignale MS1 bis MS4 mit der Endstufe 6 verbunden ist.

Die Endstufe 6 weist eine Schaltungsanordnung mit einem nicht näher bezeichneten Glättungskondensator sowie vier Schaltern S1 bis S4 und dazu parallel geschalteten nicht näher bezeichneten Freilaufdioden auf. Die Schalter S1 bis S4 werden durch die Steuersignale MS1 bis MS4 angesteuert. Dadurch sind Ausgangsspannungen der Endstufe erzeugbar, deren über eine Schaltperiode gemittelter Wert zwischen der positiven Versorgungsspannung $+U_0$ und der negativen Versorgungsspannung $-U_0$ liegen kann.

Die Versorgungsspannung $U_0$ wird durch die Energieversorgung $E_0$ zur Verfügung gestellt und ist daher Schwankungen in der Energieversorgung unterworfen. Infolge dessen unterliegt auch das Ausgangssignal $U_{out}$ der Endstufe 6 diesen Schwankungen.

Zur Kompensation dieser Schwankungen ist eine Kompensationseinrichtung 9 vorgesehen. Die Kompensationseinrichtung 9 erzeugt als Ausgangssignal einen Kompensationsfaktor k bzw. dessen Reziprokwert 1/k. Der Kompensationsfaktor k hängt von einem Parameterwert der Energieversorgung $E_0$ in weiter unten näher beschriebener Weise ab. Er wird über die Kompensator-Ausgangsleitungen 11 oder 13 der Regelungseinrichtung 1 oder der Steuerungseinrichtung 4 zugeführt, oder der Reziprokwert 1/k wird über die Kompensator-Ausgangsleitung 14 der Steuerungseinrichtung 4 zugeführt. Die Kompensator-Ausgangsleitungen 11, 13, 14 sind insofern redundant, als zu einer Kompensation durch die Kompensationseinrichtung 9 lediglich eine der drei Kompensator-Ausgangsleitungen 11, 13, 14 benötigt wird. Insofern sind sie als Alternativen zueinander zu verstehen.

Der dargestellte Verstärker 25 kann z.B. in Abhängigkeit von einer Versorgungsspannung $U_0$ eine Ausgangsspannung $U_{out}$ erzeugen, die durch die Kompensationseinrichtung 9 stabilisiert ist. In diesem Fall ermittelt die Kompensationseinrichtung 9 als Parameter der Energieversorgung $E_0$ deren Spannung, also die Versorgungsspannung $U_0$. Durch Messen der Endstufenversorgungsspannung Uo werden auch deren Spannungseinbrüche, die durch Änderung der Belastung der Endstufe entstehen, mitkompensiert. Weiter kann die Messeinrichtung 7 eine Strommesseinrichtung sein, die den durch die Ausgangsspannung $U_{out}$ der Endstufe 6 in der Spule 8 induzierten Strom misst. Ein sol-cher spannungs-abhängiger, stromgeregelter Verstärker 25 kann beispielsweise als Gradientenverstärker in einem Magnetresonanzgerät Verwendung finden, wo in schneller zeitlicher Abfolge Spulenstromänderungen, also Gradienten, erzeugt werden müssen, um schnell wechselnde magnetische Gradientenfelder zu erzeugen.

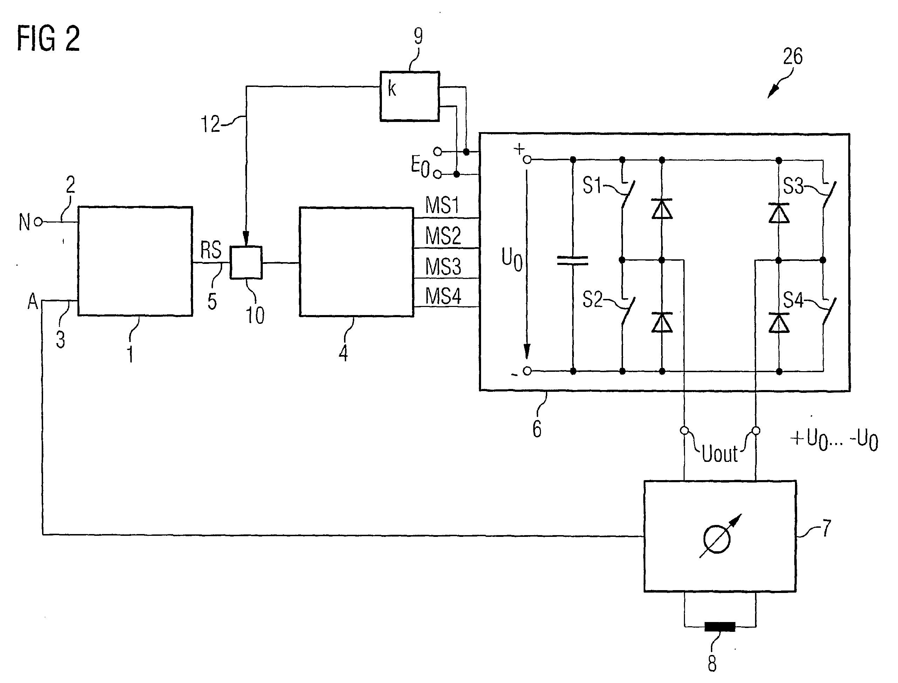

In **Figur 2** ist ein Verstärker 26 mit einer gegenüber der vorangehend beschriebenen Figur 1 abgeänderten Kompensationseinrichtung 9 dargestellt. Die Endstufe 6 samt Regelungseinrichtung 1 und Steuerungseinrichtung 4 entsprechen den vorangehend Beschriebenen und sind mit denselben Bezugszeichen bezeichnet. Die Kompensationseinrichtung 9 erzeugt ebenfalls, wie vorangehend beschrieben, einen Kompensationsfaktor k in Abhängigkeit von einem Parameterwert der Energieversorgung $E_0$. Der Kompensationsfaktor k wird über die Kompensator-Ausgangsleitung 12 einer Reglersignal-Verstärkungseinrichtung 10 zugeführt. Die Reglersignal-Verstärkungseinrichtung 10 ist eingangsseitig mit der Reglerausgangsleitung 5 verbunden und verstärkt das Reglersignal RS in Abhängigkeit von dem Kompensationsfaktor K. Auf diese Weise wirkt die Kompensationseinrichtung 9 auf die Steuerung der Endstufe 6 ein.

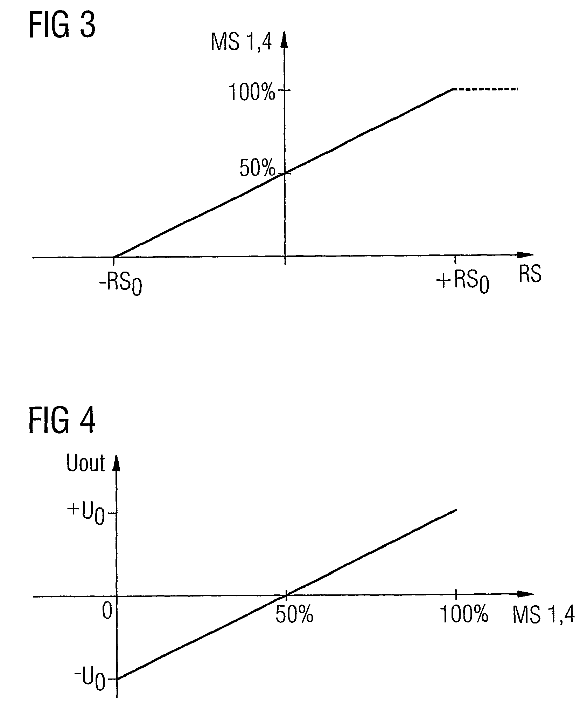

In **Figur 3** ist der Verlauf der Steuersignale MS1 und MS4 in Abhängigkeit vom Reglersignal RS dargestellt. Das Reglersignal RS kann dabei Werte innerhalb eines willkürlich festgelegten Signalbereichs von $-RS_0$ bis $+RS_0$ annehmen. Die Steuerungseinrichtung 4 kann ein analoger oder digitaler Modulator sein, der über die Signale MS1 bis MS4 die Schalter S1 bis S4 der Endstufe 6 beispielsweise derart ansteuert, dass jeweils die Schalter S1 und S4 bzw. die Schalter S2 und S3 gleichzeitig geöffnet oder geschlossen sind.

Bei einem analogen Modulator ist das Reglersignal RS üblicherweise eine Spannung, die im Modulator mit einer Dreiecksspannung als Vergleichsgröße verglichen wird. Ist RS größer als der Momentanwert der Dreiecksspannung, dann können z.B die Signale MS1 und MS4 zum Schließen der Schalter S1 und S4 gesetzt werden. Ist RS dagegen kleiner als der Momentanwert der Dreiecksspannung können stattdessen MS2 und MS 3 gesetzt werden, so dass stattdessen die Schalter S2 und S3 geschlossen sind. Bei einem digitalen Modulator kann die Vergleichsgröße ein Zählerstand sein. Ist das als Zahl vorliegende Reglersignal RS größer als der Zählerstand, so könnte wiederum beispielsweise MS1 und MS4 gesetzt werden, ist RS dagegen kleiner als der Zählerstand, so könnte stattdessen MS2 und MS3 gesetzt werden.

Sind die Schalter S1 und S4 geschlossen und S2 und S3 geöffnet, so ergibt sich als Ausgangsspannung $U_{out}$ die Spannung $+U_0$, sind dagegen umgekehrt S2 und S3 geschlossen und S1 und S4 geöffnet, so ergibt sich als Ausgangsspannung $U_{out}$ die Spannung $-U_0$. Werden die Schalter nach dem Modulationsbetrieb abwechselnd geöffnet und geschlossen, so ergibt sich als Mittelwert der Ausgangsspannung $U_{out}$ eine Spannung, die zwischen $+U_0$ und $-U_0$ liegt und von den Schaltzeiten der Schalter S1 bis S4 abhängt.

Der dargestellte Verlauf des Reglersignals RS kann also z.B. bedeuten, dass bei $-RS_0$ die Signale MS1 und MS4 nicht gesetzt und die Signale MS2 und MS3 nicht gesetzt sind. Über einen linear ansteigenden Verlauf mit dem Reglersignal RS werden die Signale MS1 und MS4 sowie MS2 und MS3 mit veränderten Schaltzeiten abwechselnd gesetzt und geöffnet, wobei bei einem Reglersignal von 0 die Schaltzeiten für S1 und S4 bzw. S2 und S3 gleich lang sind, bis dann bei einem Reglersignal von $+RS_0$ nur noch die Signale MS1 und MS1 gesetzt sind, während MS2 und MS3 nicht gesetzt sind.

In **Figur 4** ist das Ausgangssignal der Endstufe $U_{out}$ über den Steuersignalen MS1 bis MS4 aufgetragen. Ausgehend von dem Ausgangssignal $-U_0$ bei nicht gesetztem Signal für MS1 und MS4 (dafür sind hier MS2, MS3 zu 100% gesetzt) steigt das Ausgangssignal bis auf einen Wert von Null bei gleich langen Schaltzeiten für MS1 und MS4 sowie MS2 und MS3 an. Verschieben sich die Schaltzeiten weiter dahingehend, dass ausschließlich MS1 und MS4 gesetzt sind, steigt das Ausgangssignal weiter linear an, bis der maximale Wert von $+U_0$ für das Ausgangssignal der Endstufe $U_{out}$ erreicht wird.

Zusammen mit der vorhergehenden Figurenbeschreibung ergibt sich so für den Bereich des Regelsignals RS von $-RS_0$ bis $+RS_0$ ein Regelbereich für das Ausgangssignal $U_{out}$ von $-U_0$ bis $+U_0$.

Für den Zusammenhang unter den Steuersignalen MS1 bis MS4 und dem Reglersignal RS gilt dabei:

$$\mathtt{MS2,3 = 100\% - MS1,4}$$

wobei die Steuersignale MS1 bis MS4 in dieser Darstellung als prozentualer Anteil der Zeit, während der das jeweilige Steuersignal gesetzt ist, aufgefasst werden. Es gilt also z.B., dass MS1 und MS4 bei dem Wert 100% dauernd gesetzt sind, und z.B. bei dem Wert 75% während 75% der Zeit gesetzt sind. Nimmt man das Reglersignal RS hinzu, so gilt für den Zusammenhang zwischen den Steuersignalen MS1,4 und dem Reglersignal RS:

$$\mathtt{MS1,4 = 50\% + RS * 50\% / RS_0.}$$

Für den Zusammenhang zwischen den Steuersignalen MS1,4 und dem Ausgangssignal der Endstufe $U_{out}$ ergibt sich:

$$\mathtt{U_{out} = (U_0 / 50\%) * MS1,2 - U_0.}$$

Die Verstärkung der Endstufe 6 ergibt sich durch Einsetzen des obigen Zusammenhangs für MS1,4 in den vorangehenden Zusammenhang für $U_{out}$ zu:

$$\mathtt{U_{out} = (U_0 / 50\%) * (50\% + RS * 50\% / RS_0) - U_0.}$$

und daraus durch Umformen:

$$\mathtt{U_{out} = U_0 * RS / RS_0.}$$

Dadurch erhält man für die Verstärkung V der Kette aus Steuerungseinrichtung 4 und Endstufe 6:

$$\mathtt{V = U_0 / RS = U_{out} / RS_0.}$$

Die Ausgangssignal $U_{out}$ der Endstufe 6 hängt also linear vom Reglersignal RS ab. Es ist jedoch ebenso eine Abhängigkeit von der Versorgungsspannung $U_0$ gegeben. Bei einer nicht oder nur ungenügend stabilisierten Versorgungsspannung $U_0$, z.B. bei Netzschwankungen oder schnell wechselnder Last, wird eine Beeinflussung der Regeleigenschaften sichtbar. Da es in der Regel das Ziel eines Modulationsverfahrens ist, einen linearen Zusammenhang zwischen dem Ausgangssignal einer Endstufe und deren Reglersignal zu erreichen, gelten diese Überlegungen sinngemäß auch für andere, nicht ausführlich beschriebene Modulationsverfahren.

Aus der vorangehenden Gleichung ist zu ersehen, dass eine Kompensation von Schwankungen der Versor-

gungsspannung $U_0$ möglich ist durch einen Kompensationsfaktor K, für den gilt:

$$k = U_N / U_0,$$

wobei $U_N$ eine nominale oder typische, z.B. die maximale, Versorgungsspannung darstellt. Zur Kompensation wird entweder das Reglersignal RS mit dem Kompensationsfaktor k multipliziert oder der Bereich des Reglersignals um den Faktor 1/k vergrößert, so dass die Bereichsgrenzen bei $RS_0 * 1/k$ liegen.

Aus den vorangehend beschriebenen Figuren 1 und 2 ist zu ersehen, dass der Kompensationsfaktor k bzw. dessen Reziprokwert 1/k entweder der Regelungseinrichtung 1 oder der Steuerungseinrichtung 4 oder der Reglersignal-Verstärkungseinrichtung 10 zugeführt werden.

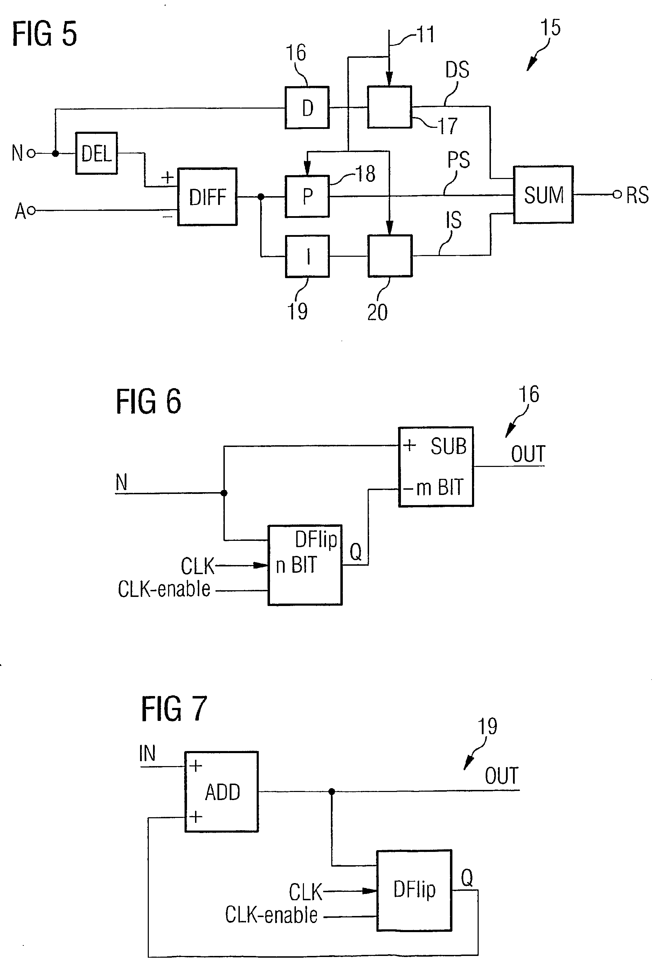

In **Figur 5** ist als Beispiel für einen in Figur 1 enthaltenen Regler ein PID-Regler mit D-Steuerung und einstellbaren Reglerparametern dargestellt. Der Sollwert N wird einem Zweig mit dem D-Glied 16 zugeführt, wobei die Verstärkung des D-Gliedes 16 einstellbar ist durch die D-Signal-Verstärkungseinrichtung 17. Die D-Signal-Verstärkungseinrichtung 17 erhält als Eingangssignal den Kompensationsfaktor k oder einen dazu proportionalen Wert über die Kompensator-Ausgangsleitung 11. Das verstärkte Ausgangssignal des D-Gliedes 16 DS wird einem Summierer zugeführt.

Der Sollwert N wird außerdem einem Verzögerungsglied DEL (Delay) zugeführt, von wo aus es einem Differenzierer (DIFF) zugeführt wird. Der Differenzierer DIFF erhält außerdem den Istwert A als Eingangssignal und bildet die Regeldifferenz zwischen Sollwert N und Istwert A. Die Regeldifferenz wird dem einstellbaren P-Glied 18 sowie dem I-Glied 19 und von dort der I-Signal-Verstärkungseinrichtung 20 zugeführt. Die Einstellung des P-Glieds 18 und der I-Signal-Verstärkungseinrichtung 20 erfolgt ebenfalls durch die Kompensator-Ausgangsleitung 11, über die der Kompensationsfaktor k oder ein dazu proportionaler Wert zugeführt wird. Das P-Signal PS sowie das I-Signal IS werden ebenso wie das D-Signal DS dem Summierer SUM zugeführt, der daraus das Reglersignal RS bildet. Der beschriebene digitale und einstellbare PID-Regler 15 kann als Regelungseinrichtung in dem vorangehend beschriebenen Verstärker der Figur 1 oder Figur 2 eingesetzt werden.

Die zum Einstellen der Regelparameter "P", "I" und "D" ohnehin notwendigen Verstärkungseinrichtungen 17, 18 und 20 können hier auch für das Einstellen des Kompensationsfaktors genutzt werden, so dass vorteilhafterweise eine zusätzliche Verstärkungseinrichtung 10 nicht nötig ist.

In **Figur 6** ist ein einfacher digitaler Aufbau für das D-Glied 16 dargestellt. Der Sollwert N wird einem n-Bit breiten Speicher, einem D-Flip-Flop DFlip sowie einem m-breiten Subtrahierer SUB zugeführt. Vorzugsweise sei m = n + 1. DFlip wird durch den Takt CLK getaktet, wobei die Taktung durch das Signal CLK-enable herabgesetzt werden kann, z.B. falls es sich bei CLK um einen schnellen Systemtakt handeln sollte.

Die Anstiegsantwort des beschriebenen digitalen D-Glieds wäre unter der Voraussetzung m = n + 1 wie nachfolgend beispielhaft tabellarisch dargestellt:

| Takt | 1 | 2 | 3 | 4 | 5 | 6 | 7 | 8 | 9 | 10 | 11 | 12 | 13 | 14 | 15 | 16 |
|------|---|---|---|---|---|---|---|---|---|----|----|----|----|----|----|----|
| N | 0 | 0 | 2 | 4 | 6 | 8 | 8 | 8 | 8 | 8 | 6 | 4 | 2 | 0 | 0 | 0 |
| Q | | 0 | 2 | 4 | 4 | 6 | 8 | 8 | 8 | 8 | 8 | 6 | 4 | 2 | 0 | 0 |
| OUT | | 0 | 2 | 2 | 2 | 2 | 0 | 0 | 0 | 0 | -2 | -2 | -2 | -2 | 0 | 0 |

In **Figur 7** ist eine digitale Ausgestaltung des I-Glieds 19 dargestellt. Das Eingangssignal IN, bei einem PID-Regler das Regeldifferenz-Signal, wird einem Addierer ADD zugeführt. Das Ausgangssignal von ADD wird einem D-Flip-Flop DFlip zugeführt, das durch ein Taktsignal CLK getaktet wird und in der Taktung durch das Signal CLK-enable herabgesetzt werden kann. Ausgangssignal Q von DFlip wird einem weiteren Eingang von ADD zugeführt. Damit ergibt das Ausgangssignal des Addierers ADD zugleich das Einganssignal der Verstärkungseinrichtung 20. Alternativ kann als Ausgang der Ausgang Q von DFlip verwendet werden, der im Vergleich zum Ausgang von ADD um einen Takt später erscheint. Die Sprungantwort des beschriebenen I-Glieds kann beispielhaft wie folgt aussehen, wobei als Startbedingung Q = 0 gilt:

| Takt | 1 | 2 | 3 | 4 | 5 | 6 | 7 | 8 | 9 | 10 | 11 | 12 | 13 | 14 | 15 | 16 |
|------|---|---|---|---|---|---|---|---|---|----|----|----|----|----|----|----|
| IN | 0 | 0 | 0 | 1 | 1 | 1 | 1 | 1 | 1 | 1 | 1 | 1 | 1 | 1 | 1 | 1 |
| Q | 0 | 0 | 0 | 0 | 1 | 2 | 3 | 4 | 5 | 6 | 7 | 8 | 9 | 10 | 11 | 12 |
| OUT | 0 | 0 | 0 | 1 | 2 | 3 | 4 | 5 | 6 | 7 | 8 | 9 | 10 | 11 | 12 | 13 |

Ein analog aufgebauter Integrierer hätte bei einer Zeitkonstante entsprechend einer Taktlänge und einer Eingangsspannung, die sich im oben angegebenen Zeitraster von null auf 1V ändert bei einer Startbedingung von 0V ebenfalls eine Ausgangsspannung, die sich wie im oben angegebenen Zeitraster angegeben mit 1V pro Taktlänge ändert. Wie aus diesen 2 Beispielen ersichtlich ist, sind analoge und entsprechend aufgebaute digitale Reglerschaltungen in ihrem Funktionsprinzip und ihren Gesetzmäßigkeiten grundsätzlich gleichwertig.

Soll die Kompensation durch den Kompensationsfaktor k oder dessen Reziprokwert in der Steuerungseinrichtung 4 folgen, so kann bei einer digitalen Steuerungseinrichtung, die einen oder mehrere Analog-Digital-Wandler zur Wandlung eines analogen Reglersignals RS aufweist, die Multiplikation des Reglersignals RS mit dem Kompensationsfaktor k bei der Analog-Digital-Wandlung durchgeführt werden, indem ein externer Referenzeingang eines der Analog-Digital-Wandler für den Maßstab der Wandlung entsprechend 1/k verwendet wird. Bei einer volldigitalen Steuerungseinrichtung 4 kann das digitale Reglersignal RS mit dem Kompensationsfaktor k multipliziert werden. Bei einer analogen Steuerungseinrichtung 4 kann sich eine günstige Schaltungsvariante ergeben, indem die Vergleichsgröße (Dreieckspannung) mit dem Reziprokwert des Kompensationsfaktors 1/k multipliziert wird. Dabei wird die in Figur 1 beschriebene Kompensator-Ausgangsleitung 14 verwendet.

Für den Kompensationsfaktor k können im Hinblick auf die praktische Anwendung des Verstärkers Grenzwerte vorgegeben werden. Geht z.B. die Versorgungsspannung $U_0$ gegen Null, so würde der Kompensationsfaktor k gegen unendlich gehen. Ein sinnvoller Betrieb des Verstärkers ist jedoch bei sehr geringen Versorgungsspannungen $U_0$ nicht möglich. Eine praxisgerechte Auslegung könnte daher auf Versorgungsspannungen $U_0$ eingeschränkt werden, die maximal etwa 30% unter dem Nennwert der Versorgungsspannung $U_0$ oder etwa 40% über deren Maximalwert liegen. Für Versorgungsspannungen $U_0$ außerhalb dieser Grenzwerte könnte der Kompensationsfaktor k dann konstant gehalten werden.

In den Überlegungen zum Zusammenhang zwischen Ausgangsspannung der Endstufe und Reglersignal wird idealisiert von einer linearen Beziehung ausgegangen. Auch wenn, z.B. durch Sicherheitszeiten in der Ansteuerung der Endstufenschalter zur Vermeidung einer Kurzschlussansteuerung, dieser ideale Zusammenhang tatsächlich nicht gegeben ist, so lässt sich mit der Einschränkung auf einen sinnvollen Arbeitsbereich eine genügende Genauigkeit der Kompensation erreichen. Andernfalls können die Nichtlinearitäten bei der Ermittlung von k berücksichtigt werden.

**Patentansprüche**

1. Gradientenverstärker für ein Magnetresonanzgerät mit einer Endstufe (6), die durch eine elektrische Energiequelle versorgbar ist, wobei die Endstufe (6) eingangsseitig mit einer Steuerungseinrichtung (4) verbunden ist, durch deren Steuersignal ein von einem Parameterwert der Energiequelle abhängiges Ausgangssignal der Endstufe (6) steuerbar ist,

   **dadurch gekennzeichnet, dass** eine Kompensationseinrichtung (9) vorgesehen ist, die mit der Energiequelle und der Steuerungseinrichtung (4) verbunden ist, und durch die das Steuersignal in Abhängigkeit von dem Parameterwert veränderbar ist.

2. Gradientenverstärker nach Anspruch 1,

   **dadurch gekennzeichnet, dass** eine Regelungseinrichtung (1) vorgesehen ist, die eingangsseitig mit der Endstufe (6) und ausgangsseitig mit der Steuerungseinrichtung (4) verbunden ist, und durch deren Reglersignal (RS) das Steuersignal in Abhängigkeit vom Ausgangssignal der Endstufe (6) regelbar ist, und dass die Regelungseinrichtung (1) mit der Kompensationseinrichtung (9) verbunden ist, und dass durch die Kompensationseinrichtung (9) das Reglersignal (RS) in Abhängigkeit von dem Parameterwert veränderbar ist.

3. Gradientenverstärker nach einem der vorhergehenden Ansprüche, **dadurch gekennzeichnet, dass** die Energiequelle als Spannungsquelle ausgebildet ist, und dass der Parameter die Versorgungsspannung ist.

4. Gradientenverstärker nach einem der vorhergehenden Ansprüche, **dadurch gekennzeichnet, dass** die Steuerungseinrichtung (4) als Pulsbreiten-Modulator ausgebildet ist.

5. Gradientenverstärker nach einem der vorhergehenden Ansprüche, **dadurch gekennzeichnet, dass** die Kompensationseinrichtung (9) derart ausgebildet ist, dass sie ein von dem Parameterwert und von einem Nominal- oder Maximalwert des Parameters abhängiges Kompensationssignal (K) erzeugen kann.

6. Gradientenverstärker nach einem der vorhergehenden Ansprüche, **dadurch gekennzeichnet, dass** die Kompensationseinrichtung (9) ausgangsseitig mit der Steuerungseinrichtung (4) oder mit der Regelungseinrichtung (1) verbunden ist.

**7.** Gradientenverstärker nach einem der vorhergehenden Ansprüche, **dadurch gekennzeichnet, dass** eine mit der Regelungseinrichtung (1) verbundene Reglersignal-Verstärkungseinrichtung (10) vorgesehen ist, und dass die Kompensationseinrichtung (9) ausgangsseitig mit der Reglersignal-Verstärkungseinrichtung (10) verbunden ist.

**8.** Magnetresonanzgerät mit einem Gradientenverstärker nach einem der vorhergehenden Ansprüche.

**9.** Verfahren zum Steuern eines Gradientenverstärker für ein Magnetresonanzgerät mit einer Endstufe (6), die durch eine elektrische Energiequelle versorgt wird, umfassend die Schritte:

- Ermitteln eines Parameterwertes der Energiequelle,
- Erzeugen eines Kompensationssignals (K) in Abhängigkeit von dem Parameterwert,
- Erzeugen eines Steuersignals in Abhängigkeit von dem Kompensationssignal (K) und
- Erzeugen eines Ausgangssignals durch die Endstufe (6) in Abhängigkeit von dem Steuersignal.

**10.** Verfahren nach Anspruch 9, umfassend die weiteren Schritte:

- Ermitteln eines Parameterwertes des Ausgangssignals,
- Erzeugen eines Reglersignals in Abhängigkeit von dem Parameterwert des Ausgangssignals, und
- Erzeugen des Steuersignals in zusätzlicher Abhängigkeit von dem Reglersignal.

**Claims**

**1.** Gradient amplifier for a magnetic resonance system, the amplifier having an output stage (6) which can be supplied by means of an electrical energy source, with the output stage (6) being connected on the input side to a control device (4) by means of whose control signal an output signal of the output stage (6) that is dependent on a parameter value of the energy source can be controlled,
**characterised in that** a compensation device (9) is provided which is connected to the energy source and the control device (4) and by means of which the control signal can be varied as a function of the parameter value.

**2.** Gradient amplifier according to claim 1,
**characterised in that** a regulating device (1) is provided which is connected on the input side to the output stage (6) and on the output side to the control device (4) and by means of whose regulator signal (RS) the control signal can be regulated as a function of the output signal of the output stage (6), that the regulating device (1) is connected to the compensation device (9), and that the regulator signal (RS) can be varied by the compensation device (9) as a function of the parameter value.

**3.** Gradient amplifier according to one of the preceding claims, **characterised in that** the energy source is embodied as a voltage source, and that the parameter is the supply voltage.

**4.** Gradient amplifier according to one of the preceding claims, **characterised in that** the control device (4) is embodied as a pulse width modulator.

**5.** Gradient amplifier according to one of the preceding claims, **characterised in that** the compensation device (9) is embodied in such a way that it can generate a compensation signal (K) that is dependent on the parameter value and on a nominal or maximum value of the parameter.

**6.** Gradient amplifier according to one of the preceding claims, **characterised in that** the compensation device (9) is connected on the output side to the control device (4) or to the regulating device (1).

**7.** Gradient amplifier according to one of the preceding claims, **characterised in that** a regulator signal amplifying device (10) connected to the regulating device (1) is provided, and that the compensation device (9) is connected on the output side to the regulator signal amplifying device (10).

**8.** Magnetic resonance system having a gradient amplifier according to one of the preceding claims.

**9.** Method for controlling a gradient amplifier for a magnetic resonance system, the gradient amplifier having an output stage (6) which is supplied by means of an electrical energy source, the method comprising the steps:

- a parameter value of the energy source is determined,
- a compensation signal (K) is generated as a function of the parameter value,
- a control signal is generated as a function of the compensation signal (K), and
- an output signal is generated by the output stage (6) as a function of the control signal.

10. Method according to claim 9, comprising the further steps:

- a parameter value of the output signal is determined,
- a regulator signal is generated as a function of the parameter value of the output signal, and
- the control signal is generated in addition as a function of the regulator signal.

**Revendications**

1. Amplificateur de gradient pour un appareil de résonance magnétique avec un étage de sortie (6), qui peut être alimenté par une source d'énergie électrique, l'étage de sortie (6) étant relié côté entrée à un dispositif de commande (4), par le signal de commande duquel un signal de sortie, dépendant d'une valeur de paramètre de la source d'énergie, de l'étage de sortie (6) peut être commandé,
**caractérisé en ce que**
il est prévu un dispositif de compensation (9) qui est relié à la source d'énergie et au dispositif de commande (4), et par lequel le signal de commande peut être modifié en fonction de la valeur de paramètre.

2. Amplificateur de gradient selon la revendication 1,
**caractérisé en ce qu'**il est prévu un dispositif de réglage (1) qui est relié côté entrée à l'étage de sortie (6) et côté sortie au dispositif de commande (4), et par le signal du régulateur duquel (RS) le signal de commande peut être réglé en fonction du signal de sortie de l'étage de sortie (6) et **en ce que** le dispositif de réglage (1) est relié au dispositif de compensation (9) et **en ce que** le signal du régulateur (RS) peut être modifié par le dispositif de compensation (9) en fonction de la valeur du paramètre.

3. Amplificateur de gradient selon l'une quelconque des revendications précédentes,
**caractérisé en ce que** la source d'énergie est conçue comme source de tension et **en ce que** le paramètre est la tension d'alimentation.

4. Amplificateur de gradient selon l'une quelconque des revendications précédentes, **caractérisé en ce que** le dispositif de commande (4) est conçu comme un modulateur d'impulsions en largeur.

5. Amplificateur de gradient selon l'une quelconque des revendications précédentes, **caractérisé en ce que** le dispositif de compensation (9) est conçu de telle sorte qu'il peut générer un signal de compensation (K) dépendant de la valeur de paramètre et d'une valeur nominale ou maximale du paramètre.

6. Amplificateur de gradient selon l'une quelconque des revendications précédentes, **caractérisé en ce que** le dispositif de compensation (9) est relié côté sortie au dispositif de commande (4) ou au dispositif de réglage (1).

7. Amplificateur de gradient selon l'une quelconque des revendications précédentes, **caractérisé en ce qu'**un dispositif d'amplification de signal du régulateur (10) relié au dispositif de réglage (1) est prévu et **en ce que** le dispositif de compensation (9) est relié côté sortie au dispositif d'amplification du signal du régulateur (10).

8. Appareil de résonance magnétique avec un amplificateur de gradient selon l'une quelconque des revendications précédentes.

9. Procédé pour la commande d'un amplificateur de gradient pour un appareil de résonance magnétique avec un étage de sortie (6), qui est alimenté par une source d'énergie électrique, comprenant les étapes suivantes :

- détermination d'une valeur de paramètre de la source d'énergie,
- génération d'un signal de compensation (K) en fonction de la valeur de paramètre,
- génération d'un signal de commande en fonction du signal de compensation (K) et
- génération d'un signal de sortie par l'étage de sortie (6) en fonction du signal de commande.

**10.** Procédé selon la revendication 9, comprenant les autres étapes suivantes :

- détermination d'une valeur de paramètre du signal de sortie,
- génération d'un signal du régulateur en fonction de la valeur de paramètre du signal de sortie, et
- génération du signal de commande en fonction supplémentaire du signal du régulateur.

# FIG 1

EP 1 685 648 B1

FIG 2

EP 1 685 648 B1

FIG 3

MS 1,4

100%

50%

-RS$_0$    +RS$_0$    RS

FIG 4

Uout

+U$_0$

0    50%    100%    MS 1,4

-U$_0$

# FIG 5

15

16

11

DS

D

17

N○ → DEL

+

DIFF

P

18

PS

A○

−

I

20

IS

19

SUM ○ RS

# FIG 6

16

N

+ SUB

OUT

− m BIT

CLK → DFlip n BIT Q

CLK-enable

# FIG 7

19

IN

+ ADD

OUT

+

CLK → DFlip Q

CLK-enable

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5559467 A
- US 5262733 A